# EUROPEAN PATENT APPLICATION

(11) **EP 2 889 969 A1**
(43) Date of publication of application: **01.07.2015**
(21) Application number: 14197772.8
(22) Date of filing: 12.12.2014
(51) Int. Cl.: H01S 5/323, G02B 27/14, G02B 27/28, H01S 5/40

(54) **Method for increasing intensity radiation of blue laser beam by combination of laser beams**

(30) Priority: 13.12.2013 SK 501432013 U
(71) Applicant: KVANT spol. s r.o., Kramare 83101 Bratislava 37 (SK)
(72) Inventor: Kubosek, Pavol, 83101 Bratislava 37 (SK); Dubec, Victor, 83101 Bratislava 37 (SK)
(74) Representative: Grünecker Patent- und Rechtsanwälte PartG mbB

(57) **Abstract**

The present invention relates to a method and apparatus for combining a plurality of laser beams into one output laser beam. In particular, a specific arrangement for combining four laser beams in a blue spectrum region is provided. A first pair of beams with the same wavelength is merged by a polarization cube (PK1) into a first combined beam (LZ1). A second pair of beams with the same wavelength (which however is different from the wavelength of the first pair) is merged by a polarization cube (PK2) into a second combined beam (LZ2). Finally, the two combined beams which have different wavelengths are merged by means of the dichroic filter (DF). Both involved wavelengths are in the blue spectrum.

## Description

Hereby presented invention relates to merging of multiple laser beams into one laser beam.

### BACKGROUND OF THE INVENTION

Show lasers are used to project laser beams mostly to accompany entertainment events. A coherent laser beam enables drawing patterns or images on walls, ceilings or theatrics smoke/fog. For this purpose, laser beams with possibly high intensity and low beam divergence are necessary.

In general, the intensity of a laser source element can be controlled by a so called pumping amplification. A typical laser comprises a gain medium (active medium) which is supplied with energy such as electric current or light. This energy supplying is called pumping. The gain medium absorbs the pumped energy, which raises some electrons into higher-energy quantum states and thus results in a stimulated emission of light. Increasing of energy density in an active medium leads not only to the increase of laser light generation but also to the increase of the active medium temperature. For each active medium, a saturation energy density exists. Energy densities greater then this saturation value do no longer contribute to the light generation increase.

Thus, in order to further increase the intensity, beams generated by a plurality of laser source elements are usually combined. For instance, a laser matrix consists of multiple closely aligned parallel laser beams. In certain distance individual beams merge into one laser beam due to the beam divergence. In other words, the beam cross-section grows with the distance from the source. Thus, at a certain distance, the cross-sections of the neighbouring beams shall only partially overlap. The resulting beam has thus relatively low-quality cross-section. This is caused for instance by the fact that the intensity distribution in such combined beam cross-section is not uniform.

The combining of the beams is also used in practice in order to obtain different colours using laser source elements which have substantially fixed spectral characteristics.

Two beams with different polarizations of light can also be combined with the help of an optical element such as a dichroic mirror or polarization cube. Polarizing cube allows two laser beams with perpendicular polarizations to be merged. One of the beams is transmitted by one of the cube's faces while the other beam which is perpendicular to the first one is reflected by another cube face in the direction of the transmitted beam.

A dichroic filter (mirror) may be used to combine two beams having different wavelengths. In particular, the dichroic mirror reflects a specific spectral band(s) and transmits the rest of the spectrum. Two beams can be merged by reflecting one incident beam from the mirror while the second beam with a wavelength outside of the reflectivity band and incident on the other side of the mirror is transmitted.

### SUMMARY OF THE INVENTION

The aim of the invention is to provide an apparatus and a method for an efficient beam combining, especially for combining of laser beams with similar wavelength in the blue spectrum.

This is achieved by the subject matter of the independent claims.

Advantageous embodiments of the invention are subject to the dependent claims.

The present invention provides a method for increasing the intensity of a laser beam especially in the blue part of the spectrum by means of laser beam combining. According to an embodiment of the invention, four laser beams generated by respective diode lasers DL₁, DL₂, DL₃ and DL₄, are combined together.

In particular, the beam from a first diode laser DL₁ is merged with the beam from a second diode laser DL₂ by means of a first polarization cube PK₁ into a first combined beam LZ₁. The beam from the first diode laser DL₁ and the beam from the second diode laser DL₂ have the same wavelength but have mutually orthogonal polarizations. This means that the plane of polarization of the beam from the first diode laser DL₁ is perpendicular to the plane of polarization of the beam from the second diode laser DL₂.

Similarly, the beam from a third diode laser DL₃ is merged with the beam from a fourth diode laser DL₄ by means of a second polarization cube PK₂ into a second combined beam LZ₂. The beam from the third diode laser DL₃ and the beam from the fourth diode laser DL₄ have the same wavelength but have mutually orthogonal polarizations. This means that the plane of polarization of the beam from the third diode laser DL₃ is perpendicular to the plane of polarization of the beam from the fourth diode laser DL₄.

The wavelength of the beam from the first diode laser DL₁ and the beam from the second diode laser DL₂ differs from the wavelength of the beam from the third diode laser DL₃ and the beam from the fourth diode laser DL₄.

The resulting two combined beams (the first combined beam LZ₁ and the second combined beam LZ₂) are not polarized. These two combined beams are further merged into a single final laser beam VZ by means of a dichroic filter DF in the following manner. One of the combined laser beams LZ₁ and LZ₂ is reflected from one side of the dichroic filter DF and the other one of the combined laser beams LZ₁ and LZ₂ having a wavelength out of the reflective range of the dichroic filter DF is projected onto the dichroic filter DF from the other side, so that after passing the dichroic filter DF it is merged with the reflected combined beam.

Advantageously, the wavelength of all combined laser beams from the respective lasers DL₁, DL₂, DL₃ and DL₄ is in the range of wavelength from 440 to 470 nm. The wavelength of one of the laser pairs (pair DL₁ and DL₂ and pair DL₃ and DL₄ respectively) is smaller than 455 nm, whereas the wavelength of the other one of the laser pairs is larger than 455 nm, wherein the difference between these two wavelengths is greater than 5 nm.

Beneficially, the dichroic filter is constructed in such a way that the location and the shape of the rising edge and the falling edge of the reflective range (on the axis of wavelength) is adapted by means of an accurate adjusting of the angle of incidence of the laser beams onto the district filter DZ.

According to an embodiment of the invention, a laser module for combining laser beams in the blue part of spectrum is provided comprising: a first diode laser (DL₁), a second diode laser (DL₂), a first polarization cube (PK₁), a third diode laser (DL₃), a fourth diode laser (DL₄), a second polarization cube (PK₂), and a dichroic filter (DF); wherein the first polarization cube (PK₁) is arranged to merge a beam from the first diode laser (DL₁) with a beam from a second diode laser (DL₂) into a first combined beam (LZ₁) wherein the first diode laser (DL₁) and the second diode laser (DL₂) are adapted to generate beams having the same wavelength but mutually orthogonal polarization planes, wherein the second polarization cube (PK₂) is arranged to merge a beam from the third diode laser (DL₃) with a beam from the fourth diode laser (DL₄) into a second combined beam (LZ₂), wherein the third diode laser (DL₃) and the fourth diode laser (DL₄) are adapted to generate beams having the same wavelength but mutually orthogonal polarization planes; the dichroic filter is arranged to merge the first combined beam (LZ₁) and the second combined beam (LZ₂) into an output laser beam (VZ), in that one of the combined laser beams (LZ₁, LZ₂) is reflected from one side of the dichroic filter (DF) and the other one of the combined laser beams (LZ₂, LZ₁) having a wavelength out of the reflective range of the dichroic filter (DF) is projected onto the dichroic filter (DF) from the other side, so that after passing the dichroic filter (DF) it is merged with the reflected combined beam.

Advantageously, the laser module according to any of claims 6 to 8, in which the diode lasers are arranged in a line, spaced equidistantly, the laser module further comprising a first mirror (Z1) for guiding the beam generated by the first diode laser to the first polarization cube; and a second mirror (Z2) for guiding the beam generated by the third diode laser to the second polarization cube.

Moreover, a system is provided comprising a plurality of the laser modules as described above, arranged to generate laser beams parallel to each other to form a laser matrix.

The above and other objects and features of the present invention will become more apparent from the following description and preferred embodiments given in conjunction with the accompanying drawings in which:
- Fig. 1: shows merging of four laser beams into one laser beam.
- Fig. 2: shows merging of eight laser beams into two parallel laser beams that form a laser matrix.

### DETAILED DESCRIPTION

The present invention concerns generating a laser beam with a high-intensity suitable for laser show applications. This is achieved by merging several laser beams generated by respective laser source elements such as laser diodes. In particular, the present invention provides a specific arrangement particularly suitable for creating a laser beam with a blue colour by combining input beams with different wavelengths in the blue spectrum. In order to obtain a high quality high-intensity laser beam, in the first stage to beams with the same wavelength are combined by means of a polarisation cube. To such combined beams with different respective wavelengths, both in the blue part of the spectrum are then combined with each other using a dichroic filter (mirror). This basic configuration can be used to provide a laser sub-module. Such sub-modules may further be used to generate beams which are merged by means of any well-known beam combining approach such as laser matrix combining.In accordance with an embodiment of the invention, the above-described single final laser beam VZ is further used as one of a plurality of laser beams to be combined in a laser matrix (one-dimensional or two-dimensional). In particular, at least two final laser beams VZ₁ and VZ₂ constructed from at least eight blue laser beams from lasers DL₁ to DL₈ are arranged in a parallel in space, thus forming a laser matrix.

The particular approach of the presented invention is merging of four blue laser beams of diode lasers DL₁, DL₂, DL₃ and DL₄ into one laser beam VZ by means of combination of two polarizing cubes PK₁ and PK₂ and one dichroic filter (mirror) DF. Among the four beams there are two pairs of beams with different wavelengths. In each pair both beams have equal wavelength but they are polarized perpendicularly to each other. Both wavelengths of the four beams are in the spectral range from 440 to 470 nm. One of the wavelengths is shorter than 455 nm while the other is longer than 455 nm and their difference is greater than 5 nm. In particular, the radiation of the merged beams is advantageously in the range of wavelengths 440 to 470 nm, wherein the wavelength of the first and the second laser DL₁, DL₂ is smaller than 450 nm and the wavelength of the third and the fourth lasers DL₃, DL₄ is larger than 460 nm. For instance, the first and the second laser may have the wavelength of 444 nm whereas the third and fourth laser may have the wavelength of 460 nm. However, this is only an example and other values may also be used, in accordance with the available laser source elements (laser diodes). Other examples may be wavelengths of 444 nm and 480 nm or 460 nm and 480 nm.

One of the advantages of the above beam combining is that a combined beam in the blue range may be generated with a high quality by merging four blue laser beams. In order to achieve this, two different polarizations are used as well as two different wavelengths in the blue range. This particular selection of these input beam wavelengths results in a high-intensity output beam with a colour slightly different to the colours of both input beams and with a better visibility for the human eye than the lower-wavelength laser.

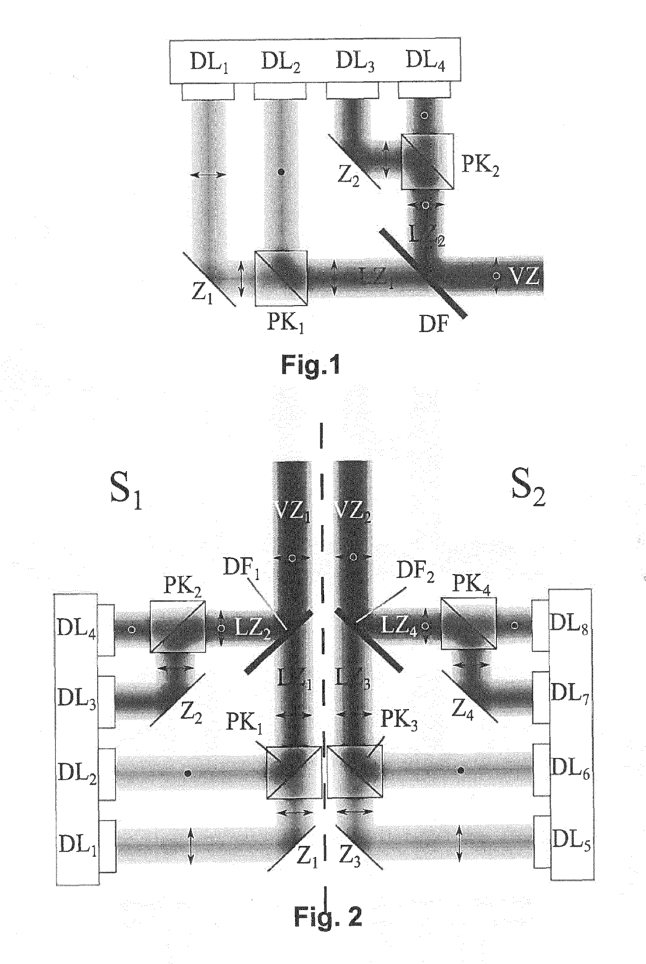

In accordance with another embodiment of the present invention the beams from the first and the second laser are combined by a first dichroic filter, while the beams of the third and the fourth laser are combined by a second dichroic filter. Here, the first and third lasers have the same wavelength which differs from the wavelength which is the same for the second and the fourth laser. The combined beams from their respective first and second dichroic filter I finally combine into an output beam by means of a polarization filter. In order to facilitate this, the first and third lasers need to have the same polarization and the second and the fourth laser also need to have the same polarization which is perpendicular to the polarization of the first and the third laser. The arrangement of such a laser module corresponds to figure 1 in which the two polarization cubes are replaced by the respective two dichroic filters, whereas the great filter DF is replaced with a polarization cube.

As described above, the beams with equal wavelengths are merged by means of polarizing cubes PK₁ and PK₂. The two non-polarized beams LZ₁ and LZ₂ formed in this manner with unequal wavelengths are merged by the dichroic filter DF. One of the beams is reflected by one side of the filter while the other beam with a wavelength outside of the reflective band of the filter is transmitted by the other side of the mirror. Thus the beam VZ is formed.

A dichroic filter is characterized by its spectral properties, in particular the portion of the incidental beam which is reflected in dependency of wavelength (or frequency). In general, in order to enable combining of beams having similar wavelength it is necessary that the dichroic filter has a sufficiently steep rising and/or falling edge possibly in the middle between the particular wavelengths of the two beams to be combined, i.e. at the central wavelength.

Moreover, the spectral properties of the dichroic filter DF such as the central wavelength, width and steepness of the edges depend also on the angle of incidence. The reflectance and transmittance efficiency can be adjusted by turning of the filter relative to the incidence beam. in this way it is possible to tune the reflective band of a suitable filter DF in order to reflect wavelengths shorter than 455 nm and transmit (pass) wavelengths longer than 455 nm. The step of adjusting the dichroic filter may compensate to certain extend the inaccuracy of the dichroic filter characteristics. It is further noted that in the above description the wavelength mentioned for the lasers are their nominal wavelength. The laser diodes may still have slightly different effective wavelengths due to some fabrication inaccuracies.

A plurality of the above described optical systems can be combined so that the resulting beams form a laser matrix. For example, at least two parallel laser beams VZ₁ a VZ₂ created by merging at least eight beams of the respective eight blue diode lasers DL₁ to DL₈ are aligned to form a laser matrix.

One of the advantages of the presented invention is its ability to merge four laser beams created by separate laser diodes into one high-quality laser beam with high optical intensity. The invention is particularly beneficial for increasing the optical intensity of laser beams with wavelengths from spectral regions where powerful laser diodes are not produced. Such region is for instance the blue region. Moreover, by combining two slightly different colours, resulting beam with a new and visually effective colour is obtained.

Fig. 1 shows schematically an apparatus which may be a stand-alone laser module or a submodule for laser beam generation. In the following, with reference to Figure 1 the corresponding method for merging four laser beams into one laser beam RB is exemplified.

The apparatus of Figure 1 includes four laser sources DL₁, DL₂, DL₃ and DL₄. The laser sources may be for instance laser diodes. However, in general the invention is also applicable to other sources. In particular, the laser sources may be laser modules which already generate a combined beam. Nevertheless, it is noted that merging of beams directly generated by the diodes or other solid state lasers provides the advantage of merging beams with a high quality.

The apparatus of Figure 1 further comprises two polarization cubes PK₁ and PK₂ each of which serves for merging of two laser beams generated by two respective laser sources. The two laser beams combined by a polarization cube have mutually orthogonal polarization. The polarization of the beam generated by a laser diode maybe controlled by means of a polarization rotator (not shown in the figure) located between the laser source and the polarization cube.

The apparatus of Figure 1 also comprises a dichroic filter (mirror) DF. A dichroic filter selectively passes light of a predefined range of colors (wavelengths) while reflecting other colors (wavelengths). Due to its partial reflectivity the filter is also called "mirror". The filter DZ is arranged in such a manner that one of the combined beams is guided onto one side of the filter DZ, while the other one of the combined beams is guided onto the other side of the filter DZ. one of the beams is reflected by the other beam is passed through the filter in such a way that the two beams are joined in a possibly concentric manner into the resulting output beam VZ. In order to achieve such beam emerging, the wavelengths of the combined beams has to differ and the filter DZ has to have spectral characteristic matching the wavelength lying between the wavelength of the merged beams as described above.

In this example, the wavelength of diode lasers DL₁ a DL₂ is longer than the wavelength of lasers DL₃ a DL₄. The light of lasers DL₁ a DL₃ is polarized horizontally. In the figure the horizontal polarization is denoted by double-headed arrows. The light generated by lasers DL₂ a DL₄ is polarized vertically which is denoted in the figure by black dots. The laser beam of the laser DL₁ merges with the beam of the laser DL₂ (after reflection of the beam from laser DL₁ by the mirror Z₁) by polarizing cube PK₁. The resulting combined beam is denoted as LZ₁. Similarly, PK₂ is used for merging beams generated by lasers DL₃ and DL₄ into the combined beam LZ₂. The combined non-polarized beams LZ₁ and LZ₂ with unequal wavelengths are finally merged by dichroic mirror DF to form the output beam VZ which is not polarized either.

It is noted that the example described with reference to figure 1 is merely illustrative. As is clear to those skilled in the art, the arrangement of the laser diodes DL₁, DL₂, DL₃ and DL₄ may differ from the arrangement shown. For instance, if laser diodes DL₁ and DL₃ are arranged in a column perpendicular to the row containing laser diodes DL₂ and DL₄, the mirrors Z₁ and Z₂ used to guide the beams generated by DL₁ and DL₃ may be omitted. Alternatively, the beams generated by the laser diodes may be guided by further or other optical elements in order to reach the optical elements for merging the beams. Accordingly, nearly any arrangement of the laser diodes is possible.

As described above, the spectral characteristic of dichroic filter on the angle of incidence of the combined laser beams. Accordingly, the apparatus shown in figure 1 may further provide means for fine adjusting of the angle of incidence of the laser beams to be merged by the filter DZ.

Fig. 2 shows two optical systems S₁ and S₂ separated by a dashed line. The two systems are identical to the system described with reference to Figure 1 above. Both systems S₁ and S₂ consist of optical elements identical to those shown in Figure 1. Parallel resulting beams RB₁ and RB₂ generated by the systems S₁ and S₂ form a laser matrix. The laser matrix in this example is a one-dimensional metrics with two elements VZ₁ and VZ₂.

It is noted that the present invention is not limited to combining of two beams generated by an apparatus as described with reference to Figure 1. In order to further increase the intensity of the beam, a plurality of the systems S₁ and S₂ similar to may be used.

Presented invention is useful in construction of high-intensity lasers with high quality beam cross section. Such lasers are applicable for instance in science, lighting, laser show, laser television and laser graphics.

Summarizing, the present invention relates to a method and apparatus for combining a plurality of laser beams into one output laser beam. In particular, a specific arrangement for combining four laser beams in a blue spectrum region is provided. A first pair of beams with the same wavelength is merged by a polarization cube into a first combined beam. A second pair of beams with the same wavelength (which however is different from the wavelength of the first pair) is merged by a polarization cube into a second combined beam. Finally, the two combined beams which have different wavelength are merged by means of the dichroic filter. Both involved wavelength are in the blue spectrum.

## Claims

1. A method for increasing the intensity of a laser beam in the blue part of the spectrum by means of laser beam combining including the steps of:
merging a beam from a first diode laser (DL₁) with a beam from a second diode laser (DL₂) by means of a first polarization cube (PK₁) into a first combined beam (LZ₁) wherein the beam from the first diode laser (DL₁) and the beam from the second diode laser (DL₂) have the same wavelength but have mutually orthogonal polarization planes,
merging a beam from a third diode laser (DL₃) with a beam from a fourth diode laser (DL₄) by means of a second polarization cube (PK₂) into a second combined beam (LZ₂), wherein the beam from the third diode laser (DL₃) and the beam from the fourth diode laser (DL₄) have the same wavelength but have mutually orthogonal polarization planes, and wherein the wavelength of the beam from the first diode laser (DL₁) and the beam from the second diode laser (DL₂) differs from the wavelength of the beam from the third diode laser (DL₃) and the beam from the fourth diode laser (DL₄),
merging the first combined beam (LZ₁) and the second combined beam (LZ₂) into an output laser beam (VZ) by means of a dichroic filter (DF) in that one of the combined laser beams (LZ₁, LZ₂) is reflected from one side of the dichroic filter (DF) and the other one of the combined laser beams (LZ₂, LZ₁) having a wavelength out of the reflective range of the dichroic filter (DF) is projected onto the dichroic filter (DF) from the other side, so that after passing the dichroic filter (DF) it is merged with the reflected combined beam.

2. The method according to claim 1, wherein the wavelength of the four laser beams from the respective four lasers (DL₁, DL₂, DL₃, DL₄) is in the range from 440 to 470 nm, wherein the wavelength of one of the laser beam pairs (DL₁, DL₂ ; DL₃, DL₄) is smaller than 455 nm, whereas the wavelength of the other one of the laser pairs is larger than 455 nm, wherein the difference between these two wavelengths is greater than 5 nm.

3. The method according to any of claims 1 or 2, wherein the dichroic filter is arranged in such a way that the location and the shape of the rising edge and the falling edge of its reflective wawelength range is adaptable by means of an accurate adjusting of the angle of incidence of the laser beams onto the district filter DZ.

4. The method according to any of claims 1 to 3, wherein the wavelength of the laser beams from the four diode lasers is in the range of wavelengths 440 to 470 nm, wherein the wavelength of the first and the second laser DL₁, DL₂ is smaller than 450 nm and the wavelength of the third and the fourth lasers DL₃, DL₄ is greater than 460 nm.

5. The method according to any of claims 1 to 4, wherein at least two respective output laser beams (VZ) are formed, each according to the method of any of claims 1 to 3 from at least 8 blue laser beams from respective diode lasers (DL1-DL8), and arranged in parallel to form a laser matrix.

6. A laser module for combining laser beams in the blue part of spectrum comprising:
a first diode laser (DL₁),
a second diode laser (DL₂),
a first polarization cube (PK₁),
a third diode laser (DL₃),
a fourth diode laser (DL₄),
a second polarization cube (PK₂), and
a dichroic filter (DF);
wherein the first polarisation cube (PK₁) is arranged to merge a beam from the first diode laser (DL₁) with a beam from a second diode laser (DL₂) into a first combined beam (LZ₁) wherein the first diode laser (DL₁) and the second diode laser (DL₂) are adapted to generate beams having the same wavelength but mutually orthogonal polarization planes,
the second polarization cube (PK₂) is arranged to merge a beam from the third diode laser (DL₃) with a beam from the fourth diode laser (DL₄) into a second combined beam (LZ₂), wherein the third diode laser (DL₃) and the fourth diode laser (DL₄) are adapted to generate beams having the same wavelength but mutually orthogonal polarization planes,
the dichroic filter is arranged to merge the first combined beam (LZ₁) and the second combined beam (LZ₂) into an output laser beam (VZ), in that one of the combined laser beams (LZ₁, LZ₂) is reflected from one side of the dichroic filter (DF) and the other one of the combined laser beams (LZ₂, LZ₁) having a wavelength out of the reflective range of the dichroic filter (DF) is projected onto the dichroic filter (DF) from the other side, so that after passing the dichroic filter (DF) it is merged with the reflected combined beam.

7. The laser module according to claim 6, wherein the wavelength of the four diode lasers (DL₁, DL₂, DL₃, DL₄) is in the range from 440 to 470 nm, wherein the wavelength of one of the laser diode pairs (DL₁, DL₂ ; DL₃, DL₄) is smaller than 455 nm, whereas the wavelength of the other one of the laser diode pairs is larger than 455 nm, and the difference between these two wavelengths is greater than 5 nm.

8. The laser module according to any of claims 6 to 7, wherein the wavelength of the laser beams from the four diode lasers is in the range of wavelengths 440 to 470 nm, wherein the wavelength of the first and the second laser DL₁, DL₂ is smaller than 450 nm and the wavelength of the third and the fourth lasers DL₃, DL₄ is greater than 460 nm.

9. The laser module according to any of claims 6 to 8, in which the diode lasers are arranged in a line, spaced equidistantly, the laser module further comprising
a first mirror (Z1) for guiding the beam generated by the first diode laser to the first polarization cube; and
a second mirror (Z2) for guiding the beam generated by the third diode laser to the second polarization cube.

10. A system comprising a plurality of the laser modules according to any of claims 6 to 10, arranged to generate laser beams parallel to each other to form a laser matrix.
